# EUROPÄISCHE PATENTSCHRIFT

(11) **EP 3 542 405 B1**
(45) Veröffentlichungstag und Bekanntmachung des Hinweises auf die Patenterteilung: **28.10.2020**
(21) Anmeldenummer: 16798176.0
(22) Anmeldetag: 18.11.2016
(51) Int. Cl.: H01L 41/083, H01L 41/273

(54) **PIEZOELEKTRISCHE SENDE- UND/ODER EMPFANGSEINRICHTUNG, VIBRATIONSSENSOR MIT EINER SOLCHEN PIEZOELEKTRISCHEN SENDE- UND/ODER EMPFANGSEINRICHTUNG SOWIE VERFAHREN ZUR HERSTELLUNG EINER PIEZOELEKTRISCHEN SENDE- UND/ODER EMPFANGSEINRICHTUNG**
PIEZOELECTRIC TRANSMISSION AND/OR RECEPTION DEVICE, VIBRATION SENSOR COMPRISING A PIEZOELECTRIC TRANSMISSION AND/OR RECEPTION DEVICE OF SAID TYPE, AND METHOD FOR MANUFACTURING A PIEZOELECTRIC TRANSMISSION AND/OR RECEPTION DEVICE
DISPOSITIF ÉMETTEUR ET/OU RÉCEPTEUR PIÉZOÉLECTRIQUE, CAPTEUR DE VIBRATIONS POURVU D'UN TEL DISPOSITIF ÉMETTEUR ET/OU RÉCEPTEUR PIÉZOÉLECTRIQUE ET PROCÉDÉ DE FABRICATION D'UN DISPOSITIF ÉMETTEUR ET/OU RÉCEPTEUR PIÉZOÉLECTRIQUE

(43) Veröffentlichungstag der Anmeldung: 25.09.2019
(73) Patentinhaber: VEGA Grieshaber KG, 77709 Wolfach (DE)
(72) Erfinder: ALLGAIER, Volker, 77761 Haslach i. K. (DE); FEHRENBACH, Dominik, 77716 Haslach (DE); GRUHLER, Holger, 78609 Tuningen (DE)
(74) Vertreter: Patentanwälte Bauer Vorberg Kayser
(86) Internationale Anmeldenummer: PCT/EP2016/078172
(87) Internationale Veröffentlichungsnummer: WO 2018/091105

(56) Entgegenhaltungen:
- CN-A- 104 219 609
- US-A1- 2003 227 357
- US-A1- 2005 016 277
- US-A1- 2010 156 250

## Beschreibung

Die vorliegende Erfindung betrifft eine piezoelektrische Sende- und/oder Empfangseinrichtung gemäß dem Oberbegriff des Patentanspruchs 1, einen Vibrationssensor mit einer solchen piezoelektrischen Sende- und/oder Empfangseinrichtung gemäß Patentanspruch 11 sowie ein Verfahren zur Herstellung einer piezoelektrischen Sende- und/oder Empfangseinrichtung gemäß Patentanspruch 12.

Aus dem Stand der Technik sind piezoelektrische Sende- und/oder Empfangseinrichtungen Vibrationssensoren mit solchem Sende- und/oder Empfangseinrichtungen, sowie Verfahren zur Herstellung von piezoelektrischen Sende- und/oder Empfangseinrichtungen bekannt, wobei die piezoelektrische Sende- und/oder Empfangseinrichtung wenigstens ein Piezoelement, wenigstens zwei Elektroden zur Kontaktierung des Piezoelements sowie wenigstens zwei Isolationselemente zur ober- und unterseitigen Isolierung umfasst, wobei die einzelnen Elemente zur Bildung der piezoelektrischen Sende- und/oder Empfangseinrichtung lose aufeinander gestapelt sind. Um eine korrekte Ausrichtung der einzelnen Bauelemente zu gewährleisten, sind diese entweder ringförmig ausgebildet und auf einem zentrisch angeordneten Bolzen angeordnet, oder die scheibenförmig ausgebildeten Bauelemente sind in einer als Gehäuse ausgebildeten Hülse relativ zueinander ausgerichtet.

Die oben beschriebenen piezoelektrischen Sende- und/oder Empfangseinrichtungen können beispielsweise in Vibrationssensoren, die häufig in der Füllstandmesstechnik als Grenzstandsensoren zum Einsatz kommen, als Sende- und/oder Empfangseinrichtung eingesetzt werden. Häufig werden solche piezoelektrischen Sende- und/oder Empfangseinrichtungen auch als Antrieb bezeichnet.

Aus der WO 01/84642 A1 ist ein elektromechanischer Antrieb in Schichtbauweise bekannt, bei dem einzelne Bauelemente, die aneinander zugewandten Oberflächen metallisiert sind, durch Diffusionsschweißen zusammengefügt sind. Um einzelne Bauelemente durch Diffusionsschweißen miteinander verbinden zu können, müssen die aneinander grenzenden Oberflächen eine sehr hohe Oberflächengüte aufweisen und die Anordnung muss bis knapp unterhalb der Soliduslinie des zum Diffusionsschweißen verwendeten Material erhitzt werden, sodass sich dann eine feste Verbindung der einzelnen Bauelemente ausbilden kann.

An dem aus dem Stand der Technik bekannten Herstellungsverfahren wird es als nachteilig empfunden, dass die für das Diffusionsschweißen vorgesehenen Bauelemente eine sehr hohe Oberflächengüte aufweisen müssen und zum Diffusionsschweißen eine sehr hohe Temperatur vorherrschen muss. Insbesondere bei piezoelektrischen Sende- und/oder Empfangseinrichtungen, wie sie der vorliegenden Anmeldung zu Grunde liegen, ist dieses Verfahren daher nur schlecht anwendbar, da die Piezoelemente bei einer Erhitzung über deren Curie-Temperatur ihre piezoelektrischen Eigenschaften verlieren und damit unbrauchbar werden können oder neu polarisiert werden müssen. Ferner sind die für das Diffusionsschweißen benötigten Bauelemente teuer in ihrer Herstellung und das Herstellungsverfahren aufwändig. Dies ist bedingt durch das aufwändige Herstellen der erforderlichen Oberflächengüte, sowie das nachträgliche Polarisieren des Piezos das typischerweise bei Spannungen von 500 bis 1.000V oder auch mehr durchgeführt wird und eine Schutzatmosphäre erfordert.

Weiterer Stand der Technik ist aus US2005/0016277, US 2010/156250 A1, CN 104 219 606 A und US 2003/227357 A1 bekannt.

Es ist die Aufgabe der vorliegenden Erfindung eine verbesserte piezoelektrische Sende- und/oder Empfangseinrichtung anzugeben. Zu deren Herstellung insbesondere deutlich niedrigere Temperaturen notwendig sind, die kostengünstiger und einfacher hergestellt werden kann. Ferner ist es eine Aufgabe der vorliegenden Erfindung ein Verfahren zur Herstellung einer solchen piezoelektrischen Sende- und/oder Empfangseinrichtung anzugeben.

Diese Aufgaben werden durch einen Vibrationssensor mit einer piezoelektrische Sende- und/oder Empfangseinrichtung mit den Merkmalen des Patentanspruchs 1 sowie ein Verfahren zur Herstellung einer piezoelektrischen Sende- und/oder Empfangseinrichtung mit den Merkmalen des Patentanspruchs 12 gelöst. Vorteilhafte Ausgestaltungen sind in abhängigen Patentansprüchen wiedergegeben.

Ein erfindungsgemäßer Vibrationssensor mit einer in Schwingung versetzter Membran, einer Spanneinrichtung zum Spannen der piezoelektrische Sende- und/oder Empfangseinrichtung gegen die Membran, derart, dass Schwingungen der Sende- und/oder Empfangseinrichtung auf die Membran und Schwingungen der Membran auf die Sende- und/oder Empfangseinrichtung übertragen werden mit einer piezoelektrischen Sende- und/oder Empfangseinrichtung bestehnd aus wenigstens einem Piezoelement, wenigstens zwei Elektroden zur Kontaktierung des Piezoelements sowie wenigstens zwei Isolationselementen zur ober- und unterseitigen Isolierung, wobei wenigstens das Piezoelement und die Elektroden zu einem Monoblock gesintert sind. Gegebenenfalls kann es auch vorteilhaft sein, eine Seite der piezoelektrischen Sende- und/oder Empfangseinrichtung auch mit dem Gehäuse elektrisch zu verbinden, um eine Erdung zu erzielen.

Dadurch, dass das Piezoelement und die Elektroden zu einem Monoblock gesintert sind, sind diese fest miteinander verbunden, sodass deren Anordnung relativ zueinander festgelegt ist. Es ist damit nicht mehr notwendig, zusätzliche Vorrichtungen oder Anordnungen zur Zentrierung von Piezoelement oder Elektroden relativ zueinander vorzusehen. Dies ist vorteilhaft, da auf diese Weise neben einer Einsparung von Bauelementen auch eine optimale Ausrichtung von Piezoelement und Elektroden relativ zueinander sichergestellt ist, was ein optimales Anlegen eines elektrischen Felds an das Piezoelement vereinfacht, da eine vollflächige und vollständig überlappende Ausrichtung von Elektroden und Piezoelement sichergestellt ist. Der Sinter-Prozess ist bei niedrigen Prozesstemperatur durchführbar, sodass das gesinterte Bauteil damit geringe innere mechanische Spannungen und somit eine hohe Güte und Standfestigkeit aufweist.

Zum Sintern wird vorzugweise ein Sintermaterial, insbesondere eine Sinterpaste oder -folie auf Silberbasis mit nanoskaligen Silberpartikeln einer Größe von 10 nm bis 15 µm verwendet.

Eine weiter vereinfachte Anordnung kann dadurch erreicht werden, dass der Monoblock zusätzlich die Isolationselemente mit umfasst. Wenn die ober- und unterseitig angeordneten und dazu entsprechenden Isolierung vorgesehenen Isolationselemente ebenfalls mit den Elektroden und dem wenigstens einen Piezoelement zu eine Monoblock gesintert sind. Auf diese Weise wird eine kompakte und einheitlich handhabbare Anordnung geschaffen.

In einer ersten Ausgestaltungsform umfasst die piezoelektrische Sende- und/oder Empfangseinrichtung eine Anzahl von n Piezoelementen und n+1 Elektroden, die wechselweise angeordnet und zu einem Monoblock gesintert sind.

In einer zweiten Ausgestaltungsform umfasst die piezoelektrische Sende- und/oder Empfangseinrichtung eine Sendeeinrichtung und eine Empfangseinrichtung, die jeweils n Piezoelemente und n+1 Elektroden, die wechselweise angeordnet sind umfassen, wobei die Sendeeinrichtung und die Empfangseinrichtung durch eine Trennkeramik voneinander elektrisch isoliert und sämtliche Komponenten zu einem Monoblock gesintert sind.

Um eine optimale Übertragung von mittels der piezoelektrischen Sende- und/oder Empfangseinrichtung erzeugten Schwingungen auf andere Elemente oder Schwingungen anderer Elemente auf die Sende- und/oder Empfangseinrichtung zu gewährleisten, kann der Monoblock zusätzlich ein Druckstück, vorzugsweise aus einem metallischen oder keramischen Werkstoff umfassen. Das Druckstück kann hierfür beispielsweise von einem Durchmesser des Monoblocks ausgehend konisch zulaufend ausgestaltet sein, sodass eine punkt- oder linienförmige Ein- und Auskopplung von Schwingungen ermöglicht wird.

Um die vorliegend beschriebene piezoelektrische Sende- und/oder Empfangseinrichtung in bereits vorhandenen Geräten mit einem zentrisch angeordneten Bolzen verwenden zu können, kann es vorteilhaft sein, wenn die Piezoelemente und die Elektroden und vorzugsweise die Isolationselemente und das Druckstück ringförmig ausgebildet sind.

Um eine größere Kraftentwicklung der piezoelektrischen Sende- und/oder Empfangseinrichtung zu erreichen, ist eine Flächenmaximierung der Piezoelemente notwendig. Dies kann besonders einfach dadurch erreicht werden, dass die Piezoelemente und die Elektroden als Kreisscheiben ausgebildet sind.

Dadurch, dass auf zusätzliche zentrierende Elemente wie einen zentrisch angeordneten Bolzen und/oder eine die Bauelemente der piezoelektrischen Sende- und/oder Empfangseinrichtung umgebende Hülse verzichtet werden kann ist es ferner möglich, einen zur Verfügung stehenden Bauraum in Radialrichtung annähernd vollständig auszunutzen, sodass eine größere Fläche zur Ausbildung des piezoelektrischen Effekts zur Verfügung steht und somit eine größere Kraftentwicklung der piezoelektrischen Sende- und/oder Empfangseinrichtung möglich ist.

In einer vorteilhaften Ausgestaltungsform weisen die Piezoelemente eine Dicke von weniger als 1,0 mmm, vorzugsweise weniger als 0,5 mm auf. Dadurch, dass die Piezoelemente mit den übrigen Komponenten der piezoelektrischen Sende- und/der Empfangseinrichtung zu einem Monoblock gesintert werden ist es möglich, diese mit einer geringeren Dicke auszugestalten, da mechanische Einwirkungen auf die Piezoelemente weiterhin vermieden werden. Insbesondere werden Oberflächenunebenheiten der Piezoelemente, der Elektroden oder der zur Isolation verwendeten Keramikelemente durch das bei der Herstellung verwendeten Sintermaterial ausgeglichen, sodass auch hier eine Minimierung mechanischer Einflüsse auf die Piezoelemente erfolgt. Dadurch, dass die Piezoelemente mit einer geringeren Dicke ausgestaltet werden können, liegt bei gleicher Betriebsspannung der piezoelektrischen Sende- und/oder Empfangseinrichtung ein höheres elektrisches Feld an den Piezoelementen an, sodass der piezoelektrische Effekt deutlich besser ausgenutzt werden kann.

Durch die Verwendung eines Sintermaterials, insbesondere einer Sinterpaste oder -folie beim Sintern der piezoelektrischen Durch die Verwendung eines Sintermaterials, insbesondere einer Sinterpaste oder -folie beim Sintern der piezoelektrischen Sende- und/oder Empfangseinrichtung ist es außerdem möglich Piezoelemente und/oder die Elektroden und/oder die Isolationselemente und/oder die Trennkeramik mit einer größeren gemittelten Rautiefe von mehr als RZ 6,3, vorzugweise mehr als RZ 16 zu verwenden. Auf diese Weise ist es möglich, insbesondere die Piezoelemente zu deutlich geringeren Kosten herzustellen, wodurch beispielsweise die Kosten für den Sinter-Prozess ganz oder zumindest teilweise kompensiert werden können.

Die gemittelte Rautiefe kann insbesondere für die Piezoelemente mehr als 6,3, für die Isolationselemente mehr als 4 und für die Metallteile mehr als 16 betragen.

Besonders niedrige Prozesstemperaturen für den Herstellungsprozess des Monoblocks können erreicht werden, wenn der Monoblock mittels eines Silber-Sinter-Verfahrens hergestellt ist. Für ein solches Silber-Sinter-Verfahren kommt vorzugweise eine Sinterpaste oder -folie mit nanoskaligem Silber zum Einsatz, da diese Prozesstemperaturen und -drucke für den Sinterprozess ermöglicht, die deutlich unterhalb der Curietemperatur von ca. 350°C der verwendeten Piezoelemente liegen.

Ein erfindungsgemäßes Verfahren zur Herstellung einer piezoelektrischen Sende- und/oder Empfangseinrichtung umfasst folgende Schritte:
- Bereitstellen von wenigstens einem Piezoelement, wenigstens zwei Elektroden zur Kontaktierung des Piezoelements sowie, wenigstens zwei Isolationselementen zur ober- und unterseitigen Isolierung,
- Beschichten wenigstens des Piezoelements auf dessen zu kontaktierenden Seiten sowie der Elektroden auf deren in fertiggestelltem Zustand der Anordnung dem Piezoelement zugesandten Seite mit einem Sintermaterial auf Silberbasis,
- ausgerichtetes Anordnen von Elektroden und Piezoelement in einem Stapel,
- Sintern des Stapels für eine vorgegebene Sinterzeit bei einer definierten Sintertemperatur zu einem Monoblock.

Das Verfahren lässt sich besonders einfach ausgestalten, wenn das Beschichten ein Aufbringen des Sintermaterials mittels Schablonendruck, einem Dispenser oder Siebdruck oder das Aufbringen einer Sinterfolie umfasst. Das Beschichten kann ferner einen Trocknungsschritt nach dem Aufbringen des Sintermaterials, insbesondere der Sinterpaste umfassen, wobei dieser beispielsweise in einem Trocknungsofen stattfinden kann.

Vorzugsweise wird für das Verfahren ein Sintermaterial mit Silberpartikeln mit einer Größe von etwa 100 nm bis etwa 500 nm verwendet. Durch die Verwendung eines Sintermaterials mit nanoskaligem Silber kann die Prozesstemperatur deutlich gesenkt werden, sodass Temperaturen von weniger als 300°C, vorzugsweise weniger als 280°C weiter bevorzugt zwischen 200° und 250°C erreicht werden können. Diese Temperaturen liegen insbesondere weit unterhalb der Curie-Temperatur üblicherweise verwendeter Piezoelemente, sodass diese ihre piezoelektrischen Eigenschaften und ihre Polarisierung beibehalten und so eine erneute Polarisierung der Piezoelemente vermieden werden kann.

Alternativ existieren auch Sinterfolien, die ein Auftragen der Paste überflüssig machen.

Durch die niedrigere Temperatur bietet das vorliegende Verfahren ferner geringe mechanische Spannungen zwischen den einzelnen Komponenten der piezoelektrischen Sende- und/oder Empfangseinrichtung.

Ferner kann bei Verwendung einer Sinterpaste mit nanoskaligem Silber das Sintern bei einem Druck von weniger als 20 MPa, vorzugsweise bei 10 MPa, weiter vorzugsweise bei Atmosphärendruck erfolgen. Es können damit die für den Sintervorgang notwendigen Apparaturen deutlich günstiger ausfallen und auf diese Weise Kosten gespart werden.

Insbesondere kann der Sinterprozess bei Umgebungsdruck und vorzugsweise unter Raumluft erfolgen.

Die vorliegende Erfindung wird nachfolgend anhand von Ausführungsbeispielen unter Bezugnahme auf die beigefügten Figuren eingehend erläutert.

Es zeigen:
- Fig. 1a: ein erstes Ausführungsbeispiel einer piezoelektrischen Sende- und/oder Empfangseinheit,
- Figur 1b: eine Ausschnittsvergrößerung aus Figur 1a in überhöhter Darstellung,
- Fig. 2: einen Vibrationssensor mit der piezoelektrischen Sende- und/oder Empfangseinheit aus Figur 1,
- Fig. 3: einen Ausschnitt aus einem Vibrationssensor mit einer piezoelektrischen Sende- und/oder Empfangseinrichtung gemäß einem zweiten Ausführungsbeispiel und
- Fig. 4: den Ablauf eines Herstellungsverfahrens

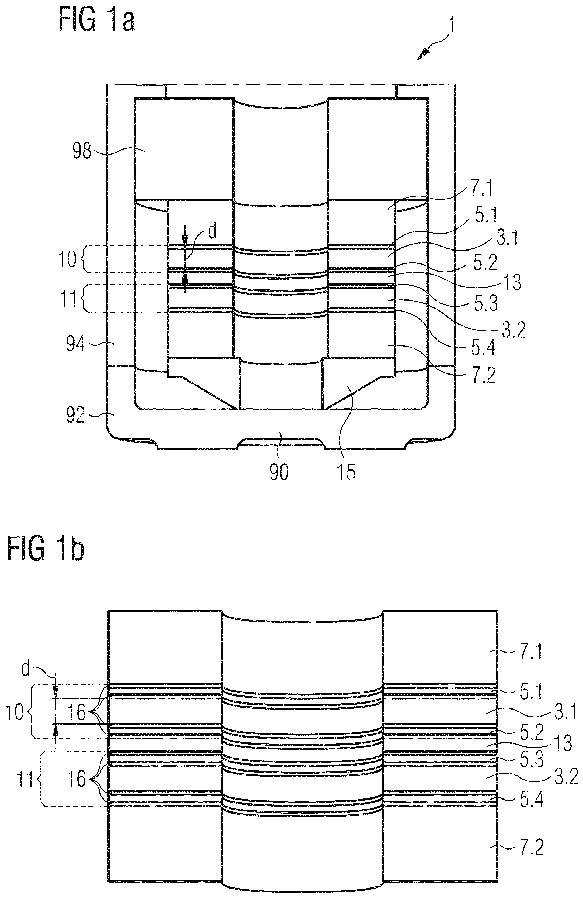

Figur 1a zeigt eine Schnittdarstellung eines ersten Ausführungsbeispiels einer piezoelektrischen Sende- und/oder Empfangseinrichtung 1 gemäß der vorliegenden Anmeldung.

Die piezoelektrische Sende- und/oder Empfangseinrichtung 1 gemäß Figur 1a ist schichtweise aufgebaut und weist mittels einer Trennkeramik 13 voneinander isoliert eine Sendeeinrichtung 10 und eine Empfangseinrichtung 11 auf, wobei die Reihenfolge auch umgekehrt sein kann.

Die Sendeeinrichtung 10 und die Empfangseinrichtung 11 sind jeweils mit einem Piezoelement 3.1, 3.2 gebildet, das jeweils über Elektroden 5.1, 5.2; 5.3, 5.4; elektrisch kontaktiert ist. In der in Figur 1 gezeigten Ausgestaltungsform ist die Sendeeinrichtung 10 oberhalb der Empfangseinrichtung 11 angeordnet, wobei zwischen der Sendeeinrichtung 10 und Empfangseinrichtung 11 die Trennkeramik 13 sitzt. Oberhalb der Sendeeinrichtung 10 ist wie auch unterhalb der Empfangseinrichtung 11 ein jeweils als Keramikscheibe ausgebildetes Isolationselements 7.1, 7.2 angeordnet. An einem membranseitigen Ende des Stapels ist ferner ein Druckstück 15 angeordnet, das unterhalb dem Isolationselement 7.2 sitzt.

Sämtliche zuvor beschriebenen Bauelemente sind mittels eines Sinter-Verfahrens basierend auf einer Sinterpaste mit nanoskaligem Silber zu einem Monoblock gesintert. Dies ermöglicht insbesondere, dass die Piezoelemente 3.1, 3.2 mit einer Dicke d von weniger als 1,0 mmm ausgebildet sein können, da durch die Ausbildung der piezoelektrischen Sende- und/oder Empfangseinrichtung 1 als ein Monoblock, sowie durch die für den Sintervorgang verwendete Sinterpaste mechanische Einflüsse auf die Piezoelemente 3.1, 3.2 weitestgehend vermieden und Oberflächenunebenheiten, die zu negativen mechanischen Einflüssen auf die Piezoelemente 3.1, 3.2 führen können durch die Sinterpaste ausgeglichen werden.

Alternativ kann auch eine Sinterfolie mit entsprechenden Eigenschaften zum Einsatz kommen.

Die piezoelektrische Sende- und/oder Empfangseinrichtung 1 ist in dem in Figur 1a gezeigten Ausführungsbeispiel in ein unterseitig von einer Membran 90 begrenztes und in Umfangsrichtung hülsenförmig ausgebildetes Gehäuse 94 eingesetzt. Das Gehäuse 94 und die Membran 90 sind an einem senkrechten zur Membranebene verlaufenden Membranrand 92 miteinander verbunden, beispielsweise verschweißt. Mittels einer Spannscheibe 98 ist die piezoelektrische Sende- und/oder Empfangseinrichtung 1 gegen die Membran 90 verspannt. Die Spannscheibe 98 kann entweder selbst oder mittels einer in Figur 1 nicht näher gezeigten Spanneinrichtung 96 in dem Gehäuse 94 fixiert sein.

In Figur 1b ist eine Ausschnittsdarstellung aus Figur 1a in überhöhter Darstellung gezeigt. In Figur 1b ist deutlich zu erkennen, dass zwischen den Piezoelementen 3.1, 3.2 und den Elektroden 5.1, 5.2, 5.3, 5.4 sowie zwischen den der Trennkeramik 13 zugewandten Elektroden 5.2, 5.3 und der Trennkeramik 13 als auch den endseitig angeordneten Elektroden 5.1, 5.4 und den Isolationselementen 7.1, 7.2 jeweils eine Sinterschicht 16 ist in Figur 1b mit überhöhter Dicke dargestellt, damit sie besser erkennbar ist.

Die Sinterschicht 16 ist dabei durch die Rückstände der Sinterpaste gebildet und stellt eine sowohl mechanische als auch leitende Verbindung zwischen den Elektroden 5.1, 5.2; 5.3, 5.4 und den Piezoelementen 3.1, 3.2 bzw. eine mechanische Verbindung zu der Trennkeramik 13 und den Isolationselementen 7.1, 7.2 her.

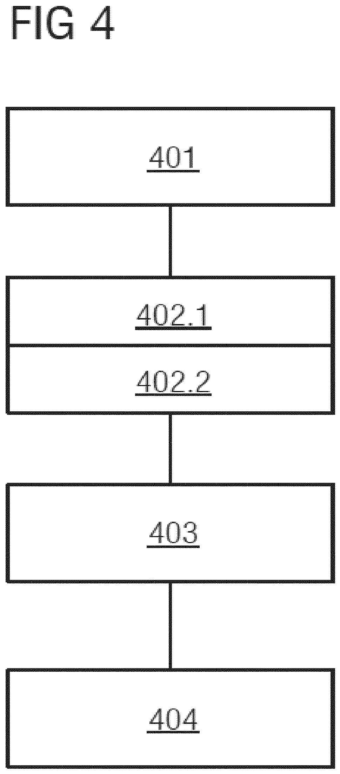

Zur Herstellung der piezoelektrischen Sende- und/oder Empfangseinrichtung werden die einzelnen Komponenten der piezoelektrischen Sende- und/oder Empfangseinrichtung 1 wie in Figur 4 zunächst dargestellt bereitgestellt (401) und anschließend an ihren jeweils zueinander weisenden Seiten mit der Sinterpaste beschichtet (402.1). Das Beschichten kann beispielsweise mit einem Schablonendruck-Verfahren, einem Dispenser oder einem Siebdruckverfahren erfolgen.

Alternativ können auch Silber-Sinterfolien zum Einsatz kommen.

Anschließend werden die Komponenten einem Trocknungsschritt (402.2) unterzogen, anschließend relativ zueinander zentriert in einem Stapel angeordnet (403) und bei einer Temperatur von 250°C und einem Druck von 10 bis 20MPa für 1 bis 3 Minuten zu einem Monoblock gesintert (404).

Bei Verwendung einer Sinterfolie ist ein Trocknungsschritt entbehrlich.

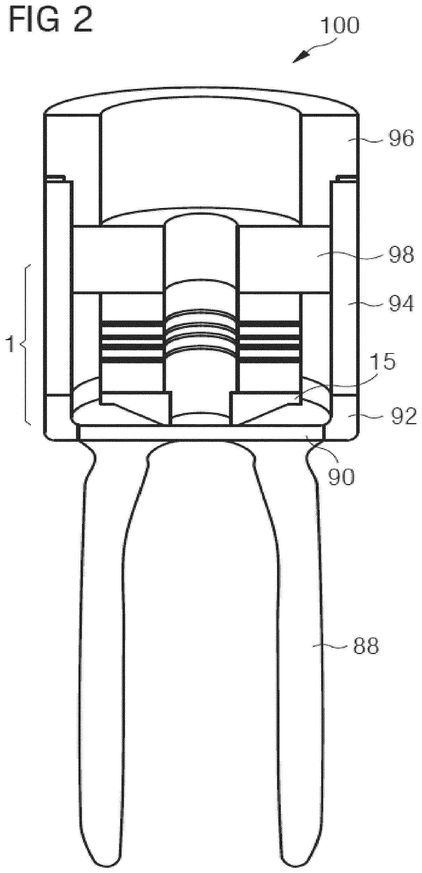

Figur 2 zeigt einen als Vibrationsgrenzstandschalter ausgebildeten Vibrationssensor 100 mit einer piezoelektrischen Sende- und/oder Empfangseinrichtung 1 gemäß Figur 1 in einer Schnittdarstellung.

Wie Figur 2 zu entnehmen ist, ist die piezoelektrische Sende- und/oder Empfangseinrichtung 1 in das Gehäuse 94 des Vibrationssensors 100 eingesetzt und mittels der Spannscheibe 98 und einer in das Gehäuse 94 eingeschraubten Spanneinrichtung 96 in Richtung der Membran 90 gespannt. Da die gesamte piezoelektrische Sende- und/oder Empfangseinrichtung 1 zu einem Monoblock gesintert ist, kann in dem in Figur 2 dargestellten Ausführungsbeispiel auf zusätzliche Elemente zur Zentrierung der piezoelektrischen Sende- und/oder Empfangseinrichtung 1 verzichtet werden.

Vorderseitig ist an der Membran 90 ein mechanischer Schwinger 88 angeordnet, der in Art einer Schwinggabel abhängig von einer Dichte und Viskosität eines ihn umgebenden Mediums auf einer Resonanzfrequenz schwingt, sodass eine Bedeckung des mechanischen Schwingers 88 mit einem Medium im Wege einer Messung der Resonanzfrequenzverschiebung detektiert werden kann.

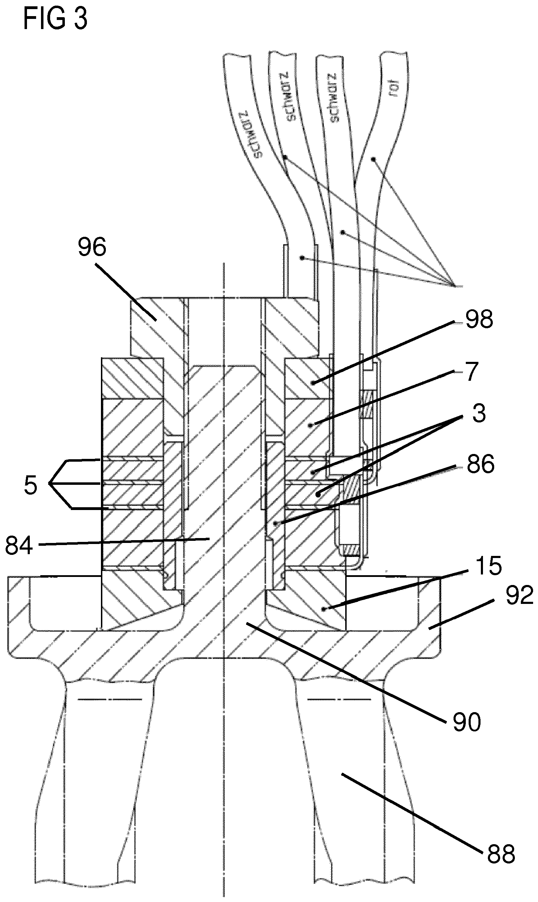

In Figur 3 ist ein Vibrationssensor 100 mit einem zweiten Ausführungsbeispiel einer piezoelektrischen Sende- und/oder Empfangseinrichtung 1 gezeigt, wobei die piezoelektrische Sende- und/oder Empfangseinrichtung 1 im vorliegenden Ausführungsbeispiel aus zwei Piezoelementen 3 mit drei die Piezoelemente 3 kontaktierenden Elektroden 5 ausgebildet ist. Wie in Figur 3 gezeigt, ist zwischen den Piezoelementen 3 und ober- und unterseitig jeweils eine Elektrode 5 vorgesehen, wobei der Stapel ober- und unterseitig mit Isolationselementen 7 fortgesetzt und isoliert ist. Membranseitig ist in dem Stapel ein Druckstück 15 angeordnet. Die zuvor beschriebenen Komponenten sind, wie zuvor beschrieben, zu einem Monoblock gesintert, sodass sie als eine Einheit handhabbar sind.

Das in Figur 3 dargestellte Ausführungsbeispiel zeigt den Aufbau eines Vibrationssensors, wie er aus dem Stand der Technik bekannt ist, wobei der Antrieb gemäß dem Stand der Technik durch einen Antrieb gemäß der vorliegenden Anmeldung, nämlich eine zu einem Monoblock gesinterten Sende- und/oder Empfangseinrichtung 1 ausgetauscht ist.

Die Spanneinrichtung 96 ist in dem in Figur 3 dargestellten Ausführungsbeispiel als Spannschraube ausgebildet, die mit einem zentrisch angeordneten Zugbolzen 84 zusammenwirkt. Eine durch die Verschraubung der Spanneinrichtung 96 mit dem Zugbolzen 84 erzeugte Kraft wird über die Spannscheibe 98 auf den Monoblock übertragen, der auf diese Weise gegen die Membran 90 gespannt ist. An der Membran 90 ist wiederum ein mechanischer Schwinger 88, der in der bereits beschriebenen Art und Weise mit einem ihn umgebenden Medium interagiert.

### Bezugszeichenliste

- 1: piezoelektrische Sende- und/oder Empfangseinrichtung

- 3: Piezoelement
- 3.1: Piezoelement
- 3.2: Piezoelement

- 5: Elektrode
- 5.1: Elektrode
- 5.2: Elektrode
- 5.3: Elektrode
- 5.4: Elektrode

- 7.1: Isolationselement
- 7.2: Isolationselement

- 10: Isolationselemente

- 11: Empfangseinrichtung

- 13: Trennkeramik

- 15: Druckstück
- 16: Sinterschicht

- 84: Zugbolzen

- 86: Isolierhülse

- 88: mechanischer Schwinger
- 90: Membran

- 92: Rand

- 94: Gehäuse
- 96: Spanneinrichtung

- 98: Spannscheibe

- 100: Vibrationssensor
- d: Dicke
- t: Sinterzeit
- T: Sintertemperatur
- p: Druck

## Patentansprüche

1. Vibrationssensor (100) mit einer piezoelektrischen Sende- und/oder Empfangseinrichtung (1) mit einer in Schwingung versetzbaren Membran (90), einer Spanneinrichtung (96) zum Spannen der piezoelektrischen Sende- und/oder Empfangseinrichtung (1) gegen die Membran (90) derart, dass Schwingungen der Sende- und/oder Empfangseinrichtung (1) auf die Membran (90) und Schwingungen der Membran (90) auf die Sende- und/oder Empfangseinrichtung (1) übertragen werden, wobei die Piezoelektrische Sende- und/oder Empfangseinrichtung (1) aus
- wenigstens einem Piezoelement (3),
- wenigstens zwei Elektroden (5) zur Kontaktierung der Piezoelemente (3) sowie,
- wenigstens zwei Isolationselementen (7) zur ober- und unterseitigen Isolierung besteht,
**dadurch gekennzeichnet, dass**
wenigstens das Piezoelement (3) und die Elektroden (5) zu einem Monoblock gesintert sind.

2. Vibrationssensor (100) mit einer piezoelektrischen Sende- und/oder Empfangseinrichtung (1) gemäß Anspruch 1,
**dadurch gekennzeichnet, dass**
der Monoblock zusätzlich die Isolationselemente (7) umfasst.

3. Vibrationssensor (100) mit einer piezoelektrische Sende- und/oder Empfangseinrichtung (1) gemäß einem der vorhergehenden Ansprüche,
**dadurch gekennzeichnet, dass**
die piezoelektrische Sende- und/oder Empfangseinrichtung (1) n Piezoelemente (3) und n+1 Elektroden (5), die wechselweise angeordnet und zu einem Monoblock gesintert sind, umfasst.

4. Vibrationssensor (100) mit einer piezoelektrische Sende- und/oder Empfangseinrichtung (1) gemäß einem der Ansprüche 1 oder 2,
**dadurch gekennzeichnet, dass**
die piezoelektrische Sende- und/oder Empfangseinrichtung (1) eine Sendeeinrichtung (10) und eine Empfangseinrichtung (11) umfasst, die jeweils n Piezoelemente (3) und n+1 Elektroden (5), die wechselweise angeordnet sind, umfassen, wobei die Sendeeinrichtung (10) und die Empfangseinrichtung (11) durch eine Trennkeramik (13) voneinander elektrisch isoliert und sämtliche Komponenten zu einem Monoblock gesintert sind.

5. Vibrationssensor (100) mit einer piezoelektrische Sende- und/oder Empfangseinrichtung (1) gemäß einem der vorhergehenden Ansprüche,
**dadurch gekennzeichnet, dass**
der Monoblock zusätzlich ein, vorzugsweise metallisches Druckstück (15) zur Übertragung einer erzeugten Schwingung umfasst.

6. Vibrationssensor (100) mit einer piezoelektrische Sende- und/oder Empfangseinrichtung (1) gemäß einem der vorhergehenden Ansprüche,
**dadurch gekennzeichnet, dass**
die Piezoelemente (3) und die Elektroden (5) als Ringscheiben ausgebildet sind.

7. Vibrationssensor (100) mit einer piezoelektrische Sende- und/oder Empfangseinrichtung (1) gemäß einem der Ansprüche 1 bis 5,
**dadurch gekennzeichnet, dass**
die Piezoelemente (3) und die Elektroden (5) als Kreisscheiben ausgebildet sind.

8. Vibrationssensor (100) mit einer piezoelektrische Sende- und/oder Empfangseinrichtung (1) gemäß einem der vorhergehenden Ansprüche,
**dadurchgekennzeichnet**, dass
die Piezoelemente (3) eine Dicke (d) von weniger als 1,0 mm, vorzugsweise weniger als 0,5 mm, aufweisen.

9. Vibrationssensor (100) mit einer piezoelektrische Sende- und/oder Empfangseinrichtung (1) gemäß einem der vorhergehenden Ansprüche,
**dadurch gekennzeichnet, dass**
die Piezoelemente (3) und/oder die Elektroden (5) und/oder die Isolationselemente (7) und/oder die Trennkeramik (13) eine gemittelte Rauhtiefe von mehr als 6,3, vorzugsweise mehr als 16 aufweisen.

10. Vibrationssensor (100) mit einer piezoelektrische Sende- und/oder Empfangseinrichtung (1) gemäß einem der vorhergehenden Ansprüche,
**dadurch gekennzeichnet, dass**
der Monoblock mittels eines Silber-Sinter-Verfahrens hergestellt ist.

11. Verfahren zur Herstellung einer piezoelektrischen Sende- und/oder Empfangseinrichtung (1) mit folgenden Schritten
- Bereitstellen von wenigstens einem Piezoelement (3), wenigstens zwei Elektroden (5) zur Kontaktierung des Piezoelements (3) sowie, wenigstens zwei Isolationselementen (7) zur ober- und unterseitigen Isolierung,
- Beschichten wenigstens des Piezoelements (3) auf dessen zu kontaktierenden Seiten sowie der Elektroden (5) auf deren in fertiggestelltem Zustand der Anordnung dem Piezoelement(3) zugewandten Seite mit einem Sintermaterial auf Silberbasis,
- ausgerichtetes Anordnen von Elektroden (5) und Piezoelement (3) in einem Stapel,
- Sintern des Stapels für eine vorgegebene Sinterzeit (t) bei einer definierten Sintertemperatur (T) zu einem Monoblock.

12. Verfahren gemäß Anspruch 11,
**dadurch gekennzeichnet, dass**
das Beschichten ein Aufbringen der Sinterpaste mittels Schablonendruck, einem Dispenser oder Siebdruck umfasst oder das Aufbringen einer Sinterfolie.

13. Verfahren nach Anspruch 11 oder 12,
**dadurch gekennzeichnet,dass**
das Beschichten einen Trocknungsschritt nach dem Aufbringen umfasst.

14. Verfahren gemäß Anspruch 11 bis 13,
**dadurch gekennzeichnet, dass**
ein Sintermaterial mit Silberpartikeln mit einer Größe von 100 nm bis 500 nm verwendet wird.

15. Verfahren gemäß einem der Ansprüche 11 bis 14,
**dadurch gekennzeichnet, dass**
die Sintertemperatur (T) weniger als 300°C, vorzugsweise weniger als 280°C, weiter vorzugsweise zwischen 200°C und 250°C, beträgt.

16. Verfahren gemäß einem der Ansprüche 11 bis 15,
**dadurch gekennzeichnet, dass**
das Sintern bei einem Druck (p) von weniger als 20 MPa, vorzugsweise bei 5MPa, weiter vorzugsweise bei Atmosphärendruck erfolgt.

## Claims

1. A vibration sensor (100) with a piezoelectric transmission and/or reception device (1) with a diaphragm (90) that can be made to vibrate, a clamping device (96) for clamping the piezoelectric transmission and/or reception device (1) against the diaphragm (90) in such a way that vibrations of the transmission and/or reception device (1) are transferred on to the diaphragm (90) and vibrations of the diaphragm (90) on to the transmission and/or reception device (1), the piezoelectric transmission and/or reception device (1) consisting of
- at least one piezo element (3),
- at least two electrodes (5) for contacting the piezo elements (3), and
- at least two insulating elements (7) for insulation at the top and the bottom,
wherein the piezo element (3) and the electrodes (5) are sintered to form a monoblock.

2. The vibration sensor (100) with a piezoelectric transmission and/or reception device (1) according to claim 1,
**characterized in that**
the monoblock additionally includes the insulating elements (7).

3. The vibration sensor (100) with a piezoelectric transmission and/or reception device (1) according to any one of the preceding claims,
**characterized in that**
the piezoelectric transmission and/or reception device (1) comprises n piezo elements (3) and n+1 electrodes (5), which are arranged in an alternating manner and are sintered to form a monoblock.

4. The vibration sensor (100) with a piezoelectric transmission and/or reception device (1) according to any one of the claims 1 or 2,
**characterized in that**
the piezoelectric transmission and/or reception device (1) comprises a transmission device (10) and a reception device (11), each of which comprises n piezo elements (3) and n+1 electrodes (5), which are arranged in an alternating manner, wherein the transmission device (10) and the reception device (11) are electrically insulated from each other by a separating ceramic body (13), and all components are sintered to form a monoblock.

5. The vibration sensor (100) with a piezoelectric transmission and/or reception device (1) according to any one of the preceding claims,
**characterized in that**
the monoblock additionally comprises a, preferably metallic, thrust member (15) for transmitting any generated vibration.

6. The vibration sensor (100) with a piezoelectric transmission and/or reception device (1) according to any one of the preceding claims,
**characterized in that**
the piezo elements (3) and the electrodes (5) are configured as annular disks.

7. The vibration sensor (100) with a piezoelectric transmission and/or reception device (1) according to any one of the claims 1 to 5,
**characterized in that**
the piezo elements (3) and the electrodes (5) are configured as circular disks.

8. The vibration sensor (100) with a piezoelectric transmission and/or reception device (1) according to any one of the preceding claims,
**characterized in that**
the piezo elements (3) have a thickness (d) of less than 1.0 mm, preferably less than 0.5 mm.

9. The vibration sensor (100) with a piezoelectric transmission and/or reception device (1) according to any one of the preceding claims,
**characterized in that**
the piezo elements (3) and/or the electrodes (5) and/or the insulating elements (7) and/or the separating ceramic body (13) have an average surface roughness of greater than 6.3, preferably greater than 16.

10. The vibration sensor (100) with a piezoelectric transmission and/or reception device (1) according to any one of the preceding claims,
**characterized in that**
the monoblock is produced by means of a silver-sintering process.

11. A method for producing a piezoelectric transmission and/or reception device (1) with the following steps
- providing at least one piezo element (3), at least two electrodes (5) for contacting the piezo element (3), and at least two insulating elements (7) for insulation at the top and the bottom,
- coating, with a silver-based sintering material, at least the piezo element (3) on the sides thereof to be contacted, and the electrodes (5) on the sides thereof facing the piezo element (3) in the finished state of the assembly,
- aligned arrangement of the electrodes (5) and the piezo element (3) in a stack,
- sintering the stack for a predetermined sintering period (t) at a defined sintering temperature (T) to form a monoblock.

12. The method according to claim 11,
**characterized in that**
the coating process comprises an application of the sintering paste by means of stencil printing, a dispenser, or screen printing, or the application of a sintering film.

13. The method according to claim 11 or 12,
**characterized in that**
the coating process comprises a drying step after the application.

14. The method according to claim 11 to 13,
**characterized in that**
a sintering material including silver particles with a size from 100 nm to 500 nm is used.

15. The method according to any one of the claims 11 to 14,
**characterized in that**
the sintering temperature (T) is less than 300°C, preferably less than 280°C, more preferably less than between 200°C and 250°C.

16. The method according to any one of the claims 11 to 15,
**characterized in that**
sintering takes place at a pressure (p) of less than 20 MPa, preferably at 5 MPa, more preferably at atmospheric pressure.

## Revendications

1. Capteur de vibrations (100) comprenant un dispositif émetteur et/ou récepteur piézoélectrique (1) comprenant une membrane (90) apte à être mise en vibrations, un dispositif de serrage (96) destiné à serrer ledit dispositif émetteur et/ou récepteur piézoélectrique (1) contre la membrane (90) de telle sorte que des vibrations du dispositif émetteur et/ou récepteur (1) sont transmises à la membrane (90) et des vibrations de la membrane (90) sont transmises au dispositif émetteur et/ou récepteur (1), dans lequel le dispositif émetteur et/ou récepteur piézoélectrique (1) se compose d'
- au moins un élément piézoélectrique (3),
- au moins deux électrodes (5) pour mettre en contact les éléments piézoélectriques (3) ainsi que
- au moins deux éléments isolants (7) pour l'isolation face supérieure et face inférieure,
dans lequel l'élément piézoélectrique (3) et les électrodes (5) sont frittés pour former un monobloc.

2. Capteur de vibrations (100) comprenant un dispositif émetteur et/ou récepteur piézoélectrique (1) selon la revendication 1, **caractérisé par le fait que** le monobloc comprend en plus les éléments isolants (7).

3. Capteur de vibrations (100) comprenant un dispositif émetteur et/ou récepteur piézoélectrique (1) selon l'une quelconque des revendications précédentes, **caractérisé par le fait que** le dispositif émetteur et/ou récepteur piézoélectrique (1) comprend n éléments piézoélectriques (3) et n+1 électrodes (5) qui sont disposés alternativement et frittés pour former un monobloc.

4. Capteur de vibrations (100) comprenant un dispositif émetteur et/ou récepteur piézoélectrique (1) selon l'une quelconque des revendications 1 ou 2, **caractérisé par le fait que** le dispositif émetteur et/ou récepteur piézoélectrique (1) comprend un dispositif émetteur (10) et un dispositif récepteur (11), qui comprennent chacun n éléments piézoélectriques (3) et n+1 électrodes (5) lesquels sont disposés alternativement, dans lequel le dispositif émetteur (10) et le dispositif récepteur (11) sont isolés l'un de l'autre électriquement par une céramique de séparation (13) et tous les composants sont frittés pour former un monobloc.

5. Capteur de vibrations (100) comprenant un dispositif émetteur et/ou récepteur piézoélectrique (1) selon l'une quelconque des revendications précédentes, **caractérisé par le fait que** le monobloc comprend en plus une pièce de pression (15), de préférence métallique, pour transmettre une vibration générée.

6. Capteur de vibrations (100) comprenant un dispositif émetteur et/ou récepteur piézoélectrique (1) selon l'une quelconque des revendications précédentes, **caractérisé par le fait que** les éléments piézoélectriques (3) et les électrodes (5) sont réalisés en tant que disques annulaires.

7. Capteur de vibrations (100) comprenant un dispositif émetteur et/ou récepteur piézoélectrique (1) selon l'une quelconque des revendications 1 à 5, **caractérisé par le fait que** les éléments piézoélectriques (3) et les électrodes (5) sont réalisés en tant que disques circulaires.

8. Capteur de vibrations (100) comprenant un dispositif émetteur et/ou récepteur piézoélectrique (1) selon l'une quelconque des revendications précédentes, **caractérisé par le fait que** les éléments piézoélectriques (3) présentent une épaisseur (d) inférieure à 1,0 mm, de préférence inférieure à 0,5 mm.

9. Capteur de vibrations (100) comprenant un dispositif émetteur et/ou récepteur piézoélectrique (1) selon l'une quelconque des revendications précédentes, **caractérisé par le fait que** les éléments piézoélectriques (3) et/ou les électrodes (5) et/ou les éléments isolants (7) et/ou la céramique de séparation (13) présentent une profondeur de rugosité moyennée supérieure à 6,3, de préférence supérieure à 16.

10. Capteur de vibrations (100) comprenant un dispositif émetteur et/ou récepteur piézoélectrique (1) selon l'une quelconque des revendications précédentes, **caractérisé par le fait que** le monobloc est réalisé au moyen d'un procédé de frittage d'argent.

11. Procédé de fabrication d'un dispositif émetteur et/ou récepteur piézoélectrique (1), comprenant les étapes suivantes consistant à
- fournir au moins un élément piézoélectrique (3), au moins deux électrodes (5) pour mettre en contact l'élément piézoélectrique (3) ainsi qu'au moins deux éléments isolants (7) pour l'isolation face supérieure et face inférieure,
- revêtir, d'un matériau fritté à base d'argent, au moins l'élément piézoélectrique (3) sur ses faces à mettre en contact ainsi que les électrodes (5) sur leur face qui montre en direction de l'élément piézoélectrique (3) lorsque l'ensemble se trouve à l'état fini,
- disposer de manière alignée les électrodes (5) et l'élément piézoélectrique (3) dans une pile,
- fritter la pile pendant un temps de frittage prédéterminé (t) à une température de frittage définie (T) pour obtenir un monobloc.

12. Procédé selon la revendication 11, **caractérisé par le fait que** le revêtement comprend une application de la pâte de frittage au moyen d'une impression au pochoir, d'un distributeur ou d'une sérigraphie, ou l'application d'un film fritté.

13. Procédé selon la revendication 11 ou 12, **caractérisé par le fait que** le revêtement comprend une étape de séchage après l'application.

14. Procédé selon la revendication 11 à 13, **caractérisé par le fait que** l'on utilise un matériau fritté ayant des particules d'argent d'une taille comprise entre 100 nm et 500 nm.

15. Procédé selon l'une quelconque des revendications 11 à 14, **caractérisé par le fait que** la température de frittage (T) est inférieure à 300 °C, de préférence inférieure à 280 °C, en outre de préférence comprise entre 200 °C et 250 °C.

16. Procédé selon l'une quelconque des revendications 11 à 15, **caractérisé par le fait que** le frittage est réalisé à une pression (p) inférieure à 20 MPa, de préférence à 5MPa, en outre de préférence à la pression atmosphérique.
